# EUROPEAN PATENT APPLICATION

(11) **EP 1 351 419 A1**
(43) Date of publication of application: **08.10.2003**
(21) Application number: 02252410.2
(22) Date of filing: 03.04.2002
(51) Int. Cl.: H04J 3/04

(54) **Method and apparatus for barrel shifting of parallel output data signals**

(71) Applicant: LUCENT TECHNOLOGIES INC., Murray Hill, New Jersey 07974-0636 (US)
(72) Inventor: Reinhold, Mario, 90419 Nuremberg (DE)
(74) Representative: Sarup, David Alexander

(57) **Abstract**

The invention relates to an apparatus and a method for bit mapping of an output data signal with respect to an ordering of a serial higher bitrate input data signal with an incoming clock signal, whereby the ordering of output data signal is initiated by a frequency division operation of the incoming clock signal and the phase relationship between the input data signal and the incoming clock signal. Thereby the division operation of the incoming clock signal comprises an inversion of the divided clock signal to perform a barrel shifting operation.

The inventive apparatus for transferring a multiplexed signal to a multiplicity of lower bitrate output signals comprises a receiving unit, wherein a high frequency signal is received and at least one demultiplexing unit adapted to demultiplex the received signal into a multiplicity of lower bitrate output signals according to a certain demultiplexing ratio as given by 1:2^{k} with a power k being an element of the quantity of natural numbers. Also at least one frequency dividing unit and an output unit with at least one output channel for emitting the multiplicity of lower bitrate output signals. The at least one exchanging unit is adapted to reorder the multiplicity of output signals to the at least one output channel corresponding to the ordering as given by the incoming high frequency signal, whereby the exchanging unit is driven by a bitmapping monitor located at the output side of the apparatus.

## Description

The invention relates to a method according to claim 1 and an apparatus in accordance with claim 5. More particularly the invention addresses the problem of an efficient and simple way of shifting, especially barrel shifting of parallel data signals (demultiplexed signals). Moreover the invention realizes barrel shifting by use of digital phase shifting.

In comparison to an ordinary shifter a barrel shifter allows to shift several bits per cycle. In addition to the ability to shift several bits at once a barrel shifter can carry out arithmetic shifting, logical shifting and also rotation function. Barrel shifting of data signals is well known and can be of advantage to overcome problems arising at data transfers using multiplexing and/or demultiplexing of signals. To clearly emphasize the principle of the present invention the application of the inventive concept to the field of multiplexing and demultiplexing respectively of data is described in the following. Firstly those problems related to multiplexing and important for the invention as well are briefly introduced.

Multiplexing and demultiplexing respectively of signals is commonly used to allow an efficient data transfer, especially in the domain of high data transfer rates. Generally a parallel stream of input data to be received from different data sources shall be transferred serially via a data bus before the output data again shall be distributed in parallel. To achieve this a multiplexing operation and a demultiplexing operation are necessary. A fundamental problem arising thereby is to keep the demultiplexed data ordered in relation to the sequential ordering of the incoming multiplexed data.

Multiplexing can of course be realized with different multiplication ratios. This can be accomplished by use a single multiplexer device with the corresponding multiplication ratio or by cascading several multiplexers, whereby the number of the multiplexers and the multiplexing ratio of each single multiplexer in combination must add up to the multiplex ratio required. It also is required that the clock signals of the corresponding data signals inversely correspond to the number of signal streams being parallel.

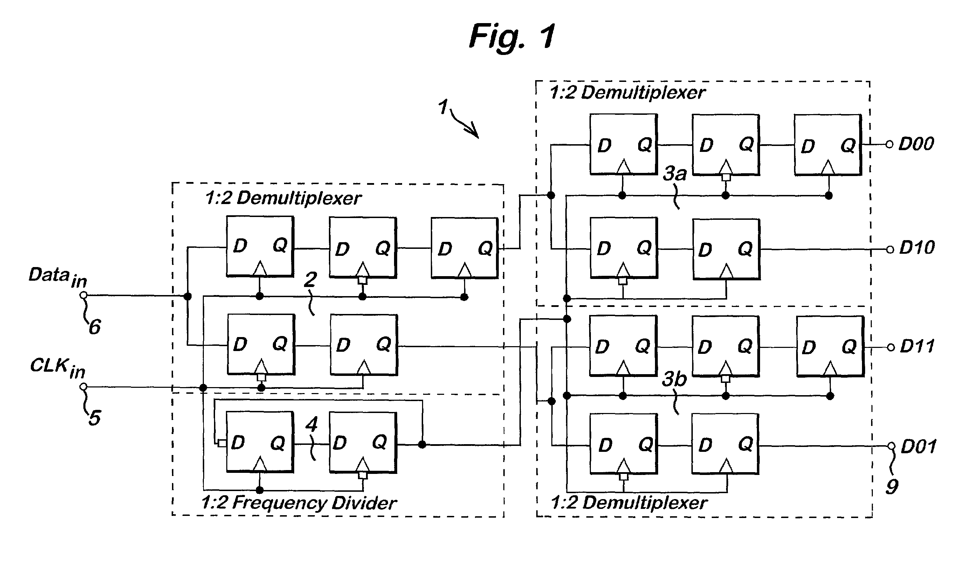

For simple demultiplexing from high bitrate signals down to parallel low bitrate signals an array of logic elements, e.g. flip-flops can be used. A version of a 1:4 demultiplexer as used in prior art is shown in Fig. 1. The features of the demultiplexer are described in the following by reference to Fig. 1 and to the reference numerals as given therein.

The demultiplexer, which as a whole is denoted by reference numeral 1, comprises a parallel structure of clocked latches. A 1:4 demultiplexing is realized by cascading a 1:2 demultiplexer 2 by two 1:2 demultiplexers 3a, 3b in parallel clocked by half of the clock frequency required for the first 1:2 demultiplexer. Frequency dividing for generating the necessary clock signals for every demultiplexer stage is needed. According to Fig. 1 a 1:2 frequency divider 4 is used to provide half clock frequency . The reduced clock frequency is generated from the clock signal fed into Clockᵢₙ-port 5.

Here, four demultiplexed channels D₀₀, D₀₁, D₁₀, D₁₁ are ordered in a way, that D₀₀ contains the earliest signal and D₁₀ contains the latest signal in time. It will be assumed, that a sixteen bit-signal is fed into the Dataᵢₙ-port 6. The sixteen bits of the bit-signal are denominated b₀₀ to b₁₅. Thereby the data eye pattern at this high bitrate side can be randomly distributed. In the situation of a 1:4-demultiplexing there are for different ways of ordering the bits to the four outgoing channels as illustrated by the following Table 1.

This degeneracy is caused firstly by the fact, that the rising edge of a clock input signal (CLKᵢₙ) may vary with respect to the data input signal Dataᵢₙ. This means that the rising edge of the clock signal may occur in the middle of the 1^{st}, the 3^{rd}, the 5^{th} bit or in the middle of the 2^{nd}, the 4^{th}, ... bit. At second the divided clock signal for the second demultiplexer stage 3a, 3b has two possible phase states (0 degrees or 180 degrees phase shifted) with respect to the clock input signal CLKᵢₙ because the divider 4 is a master-slave-flip-flop with feedback. In combination four states are possible.

Due to this the relation of a certain bit-sequence to a certain output signal channel D₀₀, D₀₁, D₁₀ and D₁₁ cannot be determined in advance. In fact under normal operating conditions the bits b₀₀ - b₁₅ are randomly distributed to the channels D₀₀ to D₁₁ as given in Table 1. Due to this multiplexed and transmitted channels cannot be directly mapped to a special receiver channel D₀₀ - D₁₁.

**Table 1**

| **State** | **D**_{**00**} | **D**_{**01**} | **D**_{**10**} | **D**_{**11**} |
|---|---|---|---|---|
| **1** | b₀₀, b₀₄, b₀₈... | b₀₁, b₀₅, b₀₉... | b₀₂, b₀₆, b₁₀... | b₀₃, b₀₇, b₁₁... |
| **2** | b₀₁, b₀₅, b₀₆... | b₀₂, b₀₆, b₁₀... | b₀₃, b₀₇, b₁₁... | b₀₀, b₀₅, b₀₉... |
| **3** | b₀₂, b₀₆, b₁₀... | b₀₃, b₀₇, b₁₁... | b₀₀, b₀₄, b₀₈... | b₀₁, b₀₅, b₀₉... |
| **4** | b₀₃, b₀₇, b₁₁... | b₀₀, b₀₄, b₀₈... | b₀₁, b₀₅, b₀₉... | b₀₂,b₀₆,b₁₀... |

Presently this uncertainty i.e. random channel mapping problem can basically be overcome by two main approaches. In one approach a barrel shifter integrated circuit (IC) can be cascaded to the output of the demultiplexer which modifies the mapping of the bits b₀₀ - b₁₅ to the channels D₀₀ - D₁₁. This solution is unfavorable because barrel shifter ICs, which can handle data input bit rates of up to 10 Gb/s, are quite cost-intense. Additional problems as mounting aspects concerning the high speed interface between the demultiplexer output and the barrel shifter input are likely to occur. These additional problems may result in signal distortion and also a higher power consumption of the high speed receiver front end.

Another rather simple approach used so far is given by switching the demultiplexer and providing a random clock phase, i.e. switching the related clock source on and off as long as the right bitmapping concerning the demultiplexer outputs D₀₀ - D₁₁ is obtained. This is possible, since the frequency divider 4 starts its operation after switching on with two possible phase states and an additional switching (on and off) of the clock source will guarantee the other two states. According to basic probability calculation the requested bitmapping shall be arranged in mean after three times of switching of the demultiplexer.

The main problem of this solution is caused by an asymmetry of the divider due to small offsets of transistors and resistors enclosed. As a consequence the phase states of the divider have not the same probability. Therefore the requested bitmapping order may need a number of switching procedures (switching on and off) definitely exceeding three, which in fact makes this approach for reliable systems not at all convenient.

It is therefore the object of the invention to provide a way of barrel shifting in which the problems according to the prior art are avoided. Especially it is the aim of the invention to remove the degeneracy of output channels of a demultiplexer system with respect to the data input signal.

The features of claim 1 and of claim 5 serve to achieve this object.

The invention is attended by the advantage that barrel shifting is reliably accomplished by performing rather basic logical operations like switching or multiplication. Also in conjunction with demultiplexing of data advantageously the right relative ordering of input and output data is achieved within a certain number of digital phase setting operations of a corresponding clock signal. A particular advantage of the invention resides in the fact, that it is possible to achieve a correction of the output bit-mapping internally within the demultiplexing unit. Consequently the problems related to interfacing of additional hardware are avoided.

The invention provides a method for bit mapping of an output data signal with respect to an ordering of a high bitrate serial input data signal with an incoming clock signal, whereby the ordering of the output data signal is initiated by at least one frequency division operation of the incoming clock signal. Thereby the at least one division operation of the incoming clock signal comprises an inversion of the divided clock signal. According to the invention barrel shifting basically is realized by providing digital phase shifting including a switching of polarities of a divided clock signal.

The invention also reveals an apparatus for transferring a multiplexed signal to a multiplicity of lower bitrate output signals. The inventive apparatus comprises a receiving unit, wherein a high frequency data signal and a corresponding clock signal are received, and at least one demultiplexing unit adapted to demultiplex the received signal into a multiplicity of lower bitrate output signals according to a certain demultiplexing ratio as given by 1:2^{k} with the power k being an element of the quantity of natural numbers. Also at least one frequency dividing unit and an output unit with at least one output channel for emitting the multiplicity of lower bitrate output signals is included. The inventive apparatus is characterized in that the at least one exchanging unit is adapted to reorder the multiplicity of output signals to the at least one output channel corresponding to the ordering as given by the incoming high frequency signal. Thereby the exchanging unit is driven by a bitmapping monitor located at the output side of the apparatus.

Advantageous developments are specified in the subclaims.

In a preferred embodiment of the present invention two phase states of the clock signals separated in phase by an 180° phase shift are supplied. In a particularly advantageous way the divided clock signal can be shifted in phase by 0° and/or 180° to perform the amount of barrel shifting required.

Furthermore the at least one frequency division operation can be achieved by cascading frequency division operations reducing the clock signal preferably by a factor of two. Thereby each frequency division operation may be identical. Finally the inventive concept provides an inversion of the divided clock signals in each division level, if requested by the bitmapping monitor at the output side. However, it is not necessary to perform a frequency division operation in the multiplexing level directly connected to the output side.

In one embodiment of the inventive apparatus the at least one exchanging unit comprises a phase shifting device. Preferably the at least one exchanging unit comprises a frequency divider adapted to divide the incoming clock signal (CLKᵢₙ) and at least one multiplier adapted for phase shifting. In another preferred embodiment the at least one exchanging unit comprises a multiplier before and behind the frequency divider, wherein the multipliers are adapted to switch the phase of the incoming clock signal (CLKᵢₙ) and the divided clock signal respectively.

The number of the multipliers in this preferred embodiment is given by k where k is defined bythe demultiplexing ratio as given by (1:2^{k}) and the number of the frequency dividers by the number of the multipliers reduced by one (k-1).

In a preferred embodiment of the invention the multipliers are used as phase switching or setting units. With advantage this proposed solution is a very simple approach for barrel shifting of demultiplexed signals. It needs only two additional multipliers within in each exchanging unit to establish the correct bitmapping of the output channels and guarantees the correct bitmapping after a maximum of (2^{k} - 1)-iterations. In such a preferred embodiment of the present invention the term switching describes an exchanging of the multiplication status of the multipliers. Then a switching operation according to the invention comprises a switching of one or the other multiplier or of both multipliers at once.

An application of the inventive concept to problems arising with multiplexing and/or demultiplexing of data signals is presented in the following. Therefore reference is made to a state of the art concept of multiplexing as already mentioned in the introductory part of the present application. Both the previous scheme as well as an exemplary embodiment of the invention are described in more detail in conjunction with the accompanying Table and drawings, in which:
- Fig. 1: depicts a state of the art scheme used for a demultiplexing operation;
- Fig. 2: depicts an exemplary architecture of an embodiment of the present invention, whereby with respect to Fig. 1 the like numerals refer to like features; and Table 1 illustrates the ordering of the signal bits to output channels of a setup as shown in Fig. 1.

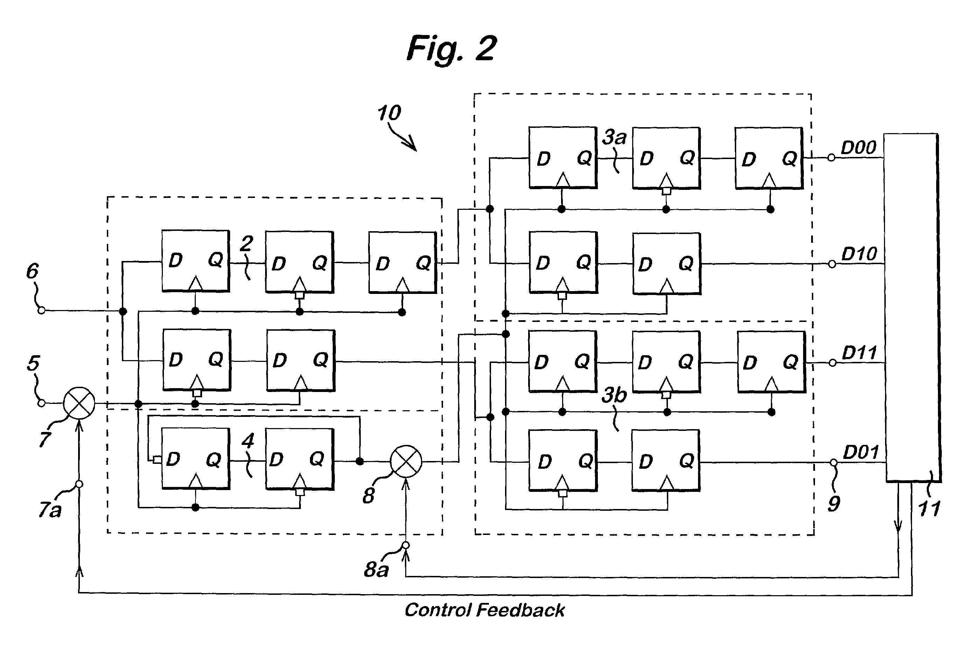

The inventive solution of bitmapping control is shown in Fig. 2 exemplified on a 1:4 demultiplexing unit 10. Preferably the 1:4 demultiplexing is done by cascading a 1:2 demultiplexer 2 by two 1:2 demultiplexers 3a, 3b in parallel clocked by half of the clock frequency required for the first 1:2 demultiplexer 2. Synchronization is established by feeding the demultiplexers 2, 3a, 3b with a clock signal corresponding to the particular multiplexing ratio. The two additional demultiplexers 3a, 3b are clocked by a clock signal, which is two times as slow as the incoming clock signal CLKᵢₙ, while demultiplexer 1 is clocked with the incoming clock frequency.

In comparison with the prior art architecture according to Figure 1 two additional multipliers 7, 8 are added in the embodiment of the invention shown in Figure 2. The first multiplier 7 is placed in the clock signal line of demultiplexer unit 10 in front of the frequency divider 4, while the second multiplier 8 is added between the frequency divider 4 and the clock signal input of the two further demultiplexers 3a, 3b. As the CLK_{IN} signal is essentially of a sine-waveform or a rectangular shape symmetric to zero the multipliers 7, 8 act as phase-shifters. Depending on input values of the multipliers 7, 8 denoted State Ctrl 1, 2 the phase of the clock signal can be shifted. By setting the input values fed into the multipliers 7, 8 via switching ports 7a, 8a a phase-shift of 180 degree or 0 degree of the CLKᵢₙ signal can be induced. The values State Ctrl 1, 2 can be set to +1 or -1, leading to four different settings for the combination of both multipliers 7, 8.

A multiplication with both State Ctrl 1, 2 values set to -1 leads to a phase shift of 180 degrees. Both State Ctrl 1, 2 values being set to +1 results in a phase-shift of 0 degree. The phase relationship of the clock-signal (CLKᵢₙ), which is fed into the latches of the first 1:2 demultiplexer 2 via clockᵢₙ-port 5, to the Dataᵢₙ signal and the phase relationship of the divided clock signal to the data signal going into the second demultiplexer stage 3a, 3b can now be controlled. Said phase relationships are simply controlled by setting the two state variables State Ctrl 1, 2 to the values {-1; +1}.

Depending on the two state variables State Ctrl 1, 2 four different states of channel bitmapping can be achieved as given in Table 1. The input values State Ctrl 1, 2 are preferably feedback-controlled via a cascaded bitmapping monitor 11, which is located on the output side of the second stage demultiplexers 3a, 3b. The bitmapping monitor 11 monitors the channel bitmapping at the output side. If it is monitored, that the channel bitmapping is not the right one, the input values State Ctrl 1, 2 will be changed in order to obtain the correct channel bitmapping at the output side 9.

Since the 1:2 frequency divider 4 resets its phase state after setting State Ctrl 1 to a certain value +1 or -1 a special sequence of setting the input values State Ctrl 1 and State Ctrl 2 is necessary. In order to get all four states of channel bitmapping within a minimum number of settings this sequence has to be kept.

According to a preferred embodiment of the invention this sequence is as follows:

At the beginning both values State Ctrl 1, 2 are set to their default values +1 and the bitmapping monitor 11 checks the mapping of the bits b₀₀ - b₁₅ to the channels D₀₀-D₁₁. If the bitmapping is correct the routine ends here.

Otherwise the value State Ctrl 2 of the multiplier 8 is set to -1. Again the bitmapping monitor 11 checks the output channel bitmapping. If the bitmapping is correct the routine ends here.

Otherwise the value State Ctrl 1 of the multiplier 7 is set to - 1 and the monitor again observes the output channel bitmapping. If the bitmapping is correct the routine ends here.

If not a further setting is necessary. Then as a third step the value State Ctrl 2 of multiplier 8 is set to +1. According to the inventive concept the bitmapping finally is correct and the routine ends here.

This sequence of setting the values State Ctrl 1, 2 guarantees to obtain the correct bitmapping after a maximum of three settings one of the State Ctrl 1, 2. In the mean only one setting of State Ctrl 2 has to be done.

The invention is not limited to the exemplary embodiment described, which can be modified in multifarious ways. Multipliers 7, 8 can be analog devices, as long as a sufficiently steep multiplication characteristic is given to guarantee a digital functioning. For example it is possible to use instead of multipliers 7, 8 other devices as long as they support a digital or quasi-digital multiplication preferably with values +1 and -1, i.e. an inversion of the clock signal. Any other device might be used as long as it is able to perform the switching operations i.e. phase shifting necessary to adapt the output bitmapping to the data input signal. However, all those devices technically equivalent to the devices discussed above with respect to their function and/or working method are within the spirit of the present invention.

It is evident, furthermore, that the invention is by no means limited to a 1:4-demultiplexing operation. An application of the inventive concept to for instance a 1:16 - demultiplexing requires a number of four devices like multipliers as well as three frequency dividers. According to the invention an adaptation of the right output bitmapping with respect to the multiplexed data input signal is at least obtained within fifteen switching operations.

Finally and to conclude, it is evident that the individual features of the invention can also be used in combinations other than those illustrated and described.

## Claims

1. Method for bit mapping of a parallel output data signal with respect to an ordering of a higher bitrate input data signal with an incoming clock signal, whereby the ordering of the output data signal is initiated by a at least one frequency division operation of the incoming clock signal,
**characterized in that**
the at least one division operation of the incoming clock signal comprises an inversion of the divided clock signal.

2. Method according to claim 1,
**characterized in that**
the divided clock signal is phase shifted by 0° and/or 180°.

3. Method according to claim 1 or 2,
**characterized in that**
the amount of phase shifting is initiated in response to a monitoring of the ordering of the output signal.

4. Method according to one of the claims 1 to 3,
**characterized in that**
the at least one frequency division is achieved by cascading frequency division operations reducing the clock signal by a factor of two.

5. Apparatus for transferring a multiplexed signal to a multiplicity of low bitrate output signals, said apparatus comprising:
- a receiving unit (5, 6), wherein a high frequency data signal (Dataᵢₙ) and clock signal (CLKᵢₙ) are received,
- at least one demultiplexing unit (2, 3a, 3b) adapted to demultiplex the received signal (Dataᵢₙ) into a multiplicity of lower bitrate output signals (D₀₀, D₀₁, D₁₀, D₁₁) according to a certain demultiplexing ratio as given by 1:2^{k} with a power k being an element of the quantity of natural numbers and
- at least one frequency dividing unit (4)
- an output unit (9, 11) with at least one output channel (D₀₀, D₀₁, D₁₀, D₁₁) for emitting the multiplicity of lower bitrate parallel output signals,
**characterized by** at least one exchanging unit (4, 7, 8) adapted to reorder the multiplicity of output signals to the at least one output channel (D₀₀, D₀₁, D₁₀, D₁₁) corresponding to the ordering as given by the incoming high frequency signal (Dataᵢₙ), whereby the at least one exchanging unit (4, 7, 8) is driven by a bitmapping monitor (11) located at the output side of the apparatus (10).

6. Apparatus according to claim 5,
**characterized in that**
the at least one exchanging unit (4, 7, 8) comprises a phase shifting device (7, 8).

7. Apparatus according to claim 5 or 6,
**characterized in that**
the at least one exchanging unit (4, 7, 8) comprises a frequency divider (4) adapted to divide the incoming clock signal (CLKᵢₙ) and at least one multiplier (7, 8) adapted for phase shifting.

8. Apparatus according to claim 7,
**characterized in that**
the at least one exchanging unit (4, 7, 8) comprises a multiplier before (7) and behind (8) the frequency divider (4), wherein the multipliers (7, 8) are adapted to switch the phase of the incoming clock signal (CLKᵢₙ) and the divided clock signal respectively.

9. Apparatus according to claim 8,
**characterized in that**
the number of the multipliers (7, 8) is given by (k), where k is defined by the demultiplexing ratio as given by (1:2^{k}) and the number of the frequency dividers (4) is given by the number of the multipliers (7, 8) reduced by one (k-1).
